(19) Europäisches Patentamt

European Patent Office

Office européen des brevets

(11) Veröffentlichungsnummer: **0 242 602 B1**

# (12) EUROPÄISCHE PATENTSCHRIFT

(45) Veröffentlichungstag der Patentschrift: **21.07.93**

(21) Anmeldenummer: **87104111.7**

(22) Anmeldetag: **20.03.87**

(51) Int. Cl.⁵: **H01J 37/10**

(54) Elektrostatisch-magnetische-Linse für Korpuskularstrahlgeräte.

(30) Priorität: **24.04.86 DE 3613915**

(43) Veröffentlichungstag der Anmeldung:
**28.10.87 Patentblatt 87/44**

(45) Bekanntmachung des Hinweises auf die
Patenterteilung:
**21.07.93 Patentblatt 93/29**

(84) Benannte Vertragsstaaten:
**AT CH DE FR GB IT LI NL SE**

(56) Entgegenhaltungen:
**EP-A- 0 088 457**
**DE-B- 1 012 398**
**US-A- 4 110 622**
**US-A- 4 419 581**

(73) Patentinhaber: **ICT Integrated Circuit Testing
Gesellschaft für Halbleiterprüftechnik mbH
Klausnerring 1a
W-8011 Heimstetten(DE)**

(72) Erfinder: **Frosien, Jürgen, Dr.
An der Ottosäule 18
W-8012 Ottobrunn(DE)**
Erfinder: **Plies, Erich, Dr.
Firlestrasse 15
W-8000 München 83(DE)**

(74) Vertreter: **Tetzner, Volkmar, Dr.-Ing. Dr. jur.
Van-Gogh-Strasse 3
W-8000 München 71 (DE)**

## Beschreibung

Die Erfindung bezieht sich auf eine elektrostatisch-magnetische-Linse für Korpuskularstrahlgeräte gemäß Oberbegriff vom Anspruch 1.

Eine derartige Linse ist aus der EP-A-0.088.457 bekannt.

In allen Bereichen der Entwicklung und Fertigung mikroelektronischer Bauelemente werden gegenwärtig Korpuskularstrahlgeräte eingesetzt, mit denen man Verfahrensschritte zur Herstellung integrierter Schaltungen kontrolliert, Masken und Wafer inspiziert oder Mikrostrukturen im Rahmen der Elektronenstrahl-Lithografie erzeugt. Besondere Bedeutung haben modifizierte, mit Gegenfeldspektrometern und schnellen Strahlaustastsystemen ausgestattete Raster-Elektronenmikroskope erlangt, mit denen Logik- und Designfehler in hochintegrierten Schaltungen, beispielsweise durch Messung des zeitlichen Spannungsverlaufes an ausgewählten Knotenpunkten, schon während der Entwicklungsphase erkannt und beseitigt werden können. Um Aufladungen und/oder Schädigungen strahlungsempfindlicher Proben zu vermeiden, betreibt man diese Geräte vorwiegend bei niedrigen Beschleunigungsspannungen zwischen etwa 0,5 und 5 kV, wo hochauflösende Untersuchungen mit konventionellen Raster-Elektronenmikroskopen nicht mehr durchführbar sind. In allen Bereichen der Halbleiterindustrie besteht deshalb ein steigender Bedarf an leistungsfähigen Niederspannungs-Rasterelektronenmikroskopen zur Durchführung schneller und hochauflösender Untersuchungen an mikroelektronischen Bauelementen.

Die durch den Strahldurchmesser d auf der Probe vorgegebene Auflösung eines Raster-Elektronenmikroskopes wird bei niedrigen Beschleunigungsspannungen im wesentlichen von der der Fokussierung entgegenwirkenden Coulomb-Abstoßung der Elektronen (Boersch-Effekt) und dem axialen Farbfehler der abbildenden Linsen bestimmt, der nach der unten angegebenen Beziehung mit dem Farbfehlerkoeffizienten $C_F$ und bei gleichbleibender Breite der Energieverteilung der Elektronen, mit abnehmender Primärenergie anwächst. Für den die Auflösung bestimmenden Sondendurchmesser d auf der Probe gilt hierbei die bekannte Beziehung

$$d = (d_0^2 + d_F^2)^{1/2}$$

wobei $d_0$ den um die Coulomb-Abstoßung der Elektronen zwischen Strahlerzeuger und Probe (lateraler Boersch-Effekt) erweiterten geometrisch-optischen Sondendurchmesser und $d_F$ den Durchmesser des durch den Farbfehler erzeugten Farbfehlerscheibchens bezeichnet, der über die Beziehung

$$d_F = C_F \cdot \alpha \cdot \Delta U/U$$

von der Strahlapertur , dem Farbfehlerkoeffizienten $C_F$ der Linse, der Primärenergie eU und der Breite der Energieverteilung e·$\Delta$U der Elektronen abhängt. Eine Verbesserung der Auflösung kann daher nur durch eine Reduktion der nachteiligen Einflüsse der Elektron-Elektron-Wechselwirkung (Reduktion des die Energiebreite e$\Delta$U beeinflussenden energetischen Boersch-Effektes und des den Sondendurchmesser beeinflussenden lateralen Boersch-Effektes) und der Farbfehlerkonstanten $C_F$ der verwendeten Linsen erreicht werden.

Aus der Veröffentlichung von R.F.W. Pease "Low Voltage Scanning Electron Microscopy" (Record of the IEEE 9th Annual Symposium on Electron, Ion and Laser Beam Technology, Berkeley, 9-11 May 1967, Seite 176-187) ist ein Rasterelektronenmikroskop bekannt, in dem die zunächst auf hohe kinetische Energien beschleunigten Primärelektronen in einem unmittelbar oberhalb der Probe aufgebauten elektrischen Gegenfeld auf die gewünschte niedrige Endenergie abgebremst werden. Durch Messung des Strahlquerschnittes auf der Probe konnte man zeigen, daß die Objektivlinse der Anordnung bei Gegenfeldbetrieb deutlich kleinere Farb- und Öffnungsfehlerkonstanten als die magnetische Einzellinse bei konventionellem Betrieb ohne Gegenfeld aufweist.

Aus der bereits genannten EP-A-0 088 457 ist eine Linsenanordnung bekannt, bei der in einer Magnetlinse eine durch eine Anzahl von Zylindern gebildete elektrische Linse angeordnet ist. Die magnetische Linse dient hierbei zur Grobfokussierung, während die elektrische Linse zur Feinfokussierung vorgesehen ist. Die Energie des Strahles ist dabei vor und nach der Linsenanordnung gleich.

Aus der US-A-4,110,622 ist eine ähnliche Linsenanordnung offenbart, die sich im wesentlichen lediglich durch eine etwas andere Ausgestaltung der elektrostatischen Linse unterscheidet. Auch hier ist die Energie des Strahles nach der Linsenanordnung unverändert.

Der Erfindung liegt die Aufgabe zugrunde eine Linse für Korpuskularstrahlgeräte anzugeben, mit der hochenergetische Korpuskeln auf eine gewünschte Endenergie abgebremst werden können und die kleinere Farb- und Öffnungsfehlerkonstanten als konventionelle Magnetlinsen aufweist. Diese Aufgabe wird erfindungsgemäß durch eine elektrostatisch-magnetische-Linse nach Anspruch 1 gelöst.

Der mit der Erfindung erzielbare Vorteil besteht insbesondere darin, daß auch bei hohen Strahlströmen und niedrigen Beschleunigungsspannungen Korpuskularsonden mit kleinem Strahlquerschnitt erzeugt werden können.

Die Ansprüche 2 bis 10 sind auf bevorzugte Ausgestaltungen und Weiterbildungen der Erfindung gerichtet.

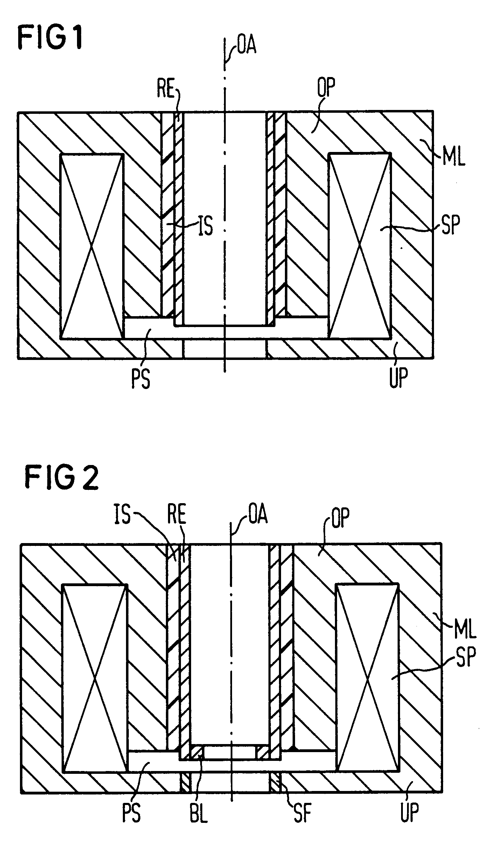

Die Erfindung wird nachfolgend anhand der Zeichnungen näher erläutert, dabei zeigen die Figuren 1 bis 4 erfindungsgemäße elektrostatisch-magnetische-Linsen.

Die in Fig.1 dargestellte elektrostatische Magnetlinse besteht aus einer symmetrischen (d. h. die Durchmesser des oberen und unteren Polschuhes sind gleich) oder unsymmetrischen (d. h. die Durchmesser des oberen und unteren Polschuhes sind verschieden) Magnetlinse ML, der eine elektrostatische Immersionslinse überlagert ist. Um möglichst kleine Brennweiten zu erzielen, wird der mit Hilfe der Erregerspule SP erzeugte magnetische Fluß über die Polschuhe UP und OP geführt und auf einen kleinen Raumbereich um die Symmetrieachse OA des Systems konzentriert, wobei das um diese Achse rotationssymmetrische Magnetfeld seine maximale Stärke im Polschuhspalt PS erreicht. Eine Elektrode der Immersionslinse ist in dem gezeigten Ausführungsbeispiel in Form eines Hohlzylinders RE ausgebildet, der zusammen mit einem ebenfalls zylinderförmigen Isolator IS im oberen Polschuh OP der Magnetlinse ML konzentrisch zu deren Symmetrieachse OA angeordnet wird, und sich bis in den Bereich des Polschuhspaltes PS erstreckt. Der untere Polschuh der Magnetlinse ML, der vorzugsweise auf Erdpotential liegt und, wie in Fig. 2 dargestellt, zum Schutz gegen Kontamination mit einem Strahlführungsrohr SF aus magnetischem oder unmagnetischem Material ausgekleidet sein kann, bildet erfindungsgemäß die untere Elektrode der elektrostatischen Immersionslinse. Ein rotationssymmetrisches elektrisches Verzögerungsfeld baut sich innerhalb der Magnetlinse ML immer dann auf, wenn die Zylinderelektrode RE bezüglich des unteren Polschuhes UP auf positives Potential, insbesondere auf das Potential der Anode des Korpuskularstrahlerzeugers gelegt wird.

Die Abbildungseigenschaften der aus elektrostatischer Immersionslinse und Magnetlinse bestehenden korpuskular-optischen Einheit werden im wesentlichen von den Spannungen der Elektroden und deren Abmessungen und der Magnetfeldstärke im Polschuhspalt PS bestimmt. Es ist deshalb keineswegs erforderlich, daß die Zylinderelektrode RE und die untere Polschuhöffnung gleichen Durchmesser aufweisen.

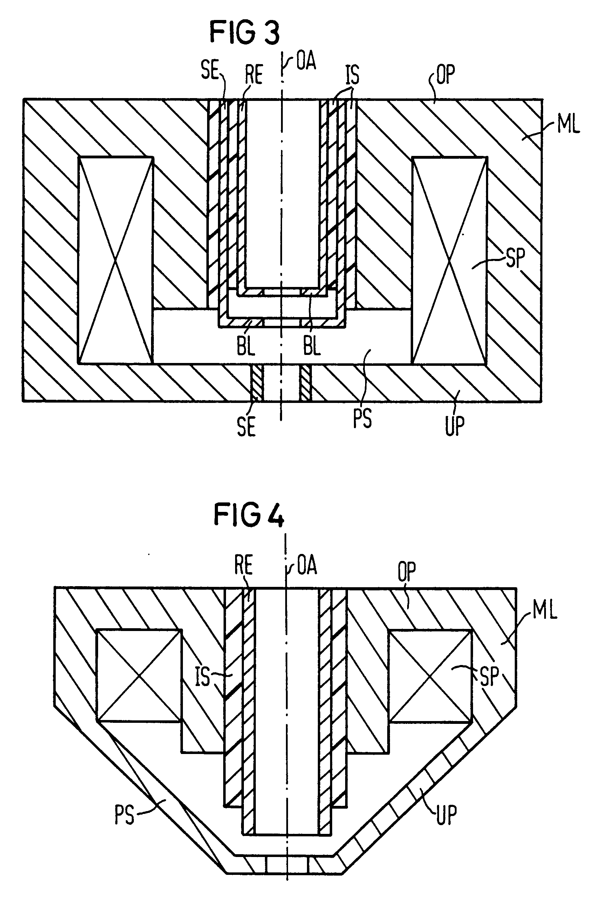

Die Lage der Zylinderelektrode RE innerhalb der Magnetlinse ML, ihr Durchmesser und ihr Abstand vom unteren Polschuh UP müssen vielmehr den geforderten korpuskular-optischen Eigenschaften des Gesamtsystems angepaßt werden. So läßt sich die Brennweite der elektrostatischen Immersionslinse mit Hilfe einer kreisförmigen Lochblende BL verändern, die innerhalb der Zylinderelektrode RE angeordnet wird oder diese, wie in Fig. 2 dargestellt, im Bereich des Polschuhspaltes PS abschließt. Eine kontinuierliche Veränderung der Brennweite ist möglich, wenn man zwei koaxial liegende Zylinderelektroden RE bzw. SE unterschiedlicher Länge im oberen Polschuhes OP anordnet und die als Steuerelektrode wirkende äußere Zylinderelektrode SE mit geeigneten Spannungen beaufschlagt (siehe Fig. 3). Jede der Zylinderelektroden RE bzw. SE kann hierbei wieder von einer kreisförmigen Lochblende BL abgeschlossen werden.

Die erfindungsgemäßen elektrostatisch-magnetischen-Linsen besitzen aufgrund des dem fokussierenden Magnetfeld überlagerten elektrischen Verzögerungsfeldes deutlich kleinere Öffnungs- und Farbfehlerkonstanten als magnetische Einzellinsen. So werden die im wesentlichen von der Potentialdifferenz zwischen Zylinderelektrode RE und unterem Polschuh UP bestimmten Fehlerkonstanten des zusammengesetzten Systems, verglichen mit den Fehlerkonstanten der magnetischen Einzellinse beispielsweise, um etwa einen Faktor 10 reduziert, wenn man die Korpuskeln im elektrischen Verzögerungsfeld der Immersionslinse auf 1/10 ihrer Primärenergie (kinetische Energie im Strahlengang unmittelbar oberhalb der erfindungsgemäßen Linse) abbremst. Die erfindungsgemäßen Linsen besitzen außerdem den Vorteil, daß sich deren leicht berechenbare korpuskular-optische Eigenschaften aufgrund der ausgezeichneten Zentrierbarkeit von elektrischer und magnetischer Linse sehr gut in der Praxis realisieren lassen.

Eine elektrostatisch-magnetische Linse mit konischer (d. h. einen konischen Polschuh aufweisende) Magnetlinse ML ist in Fig.4 dargestellt, in der gleiche Bezugszeichen gleiche Anordnungselemente wie in den Fig. 1 bis 3 bezeichnen. Konische Objektivlinsen werden beispielsweise in Rasterelektronenmikroskopen eingesetzt, um großflächige Präparate auch in gekipptem Zustand bei kleinem Arbeitsabstand abbilden und untersuchen zu können. Aufgrund ihrer Polschuhform besitzen konische Magnetlinsen allerdings einen großen Spalt PS und damit eine Vergleichsweise lange Brennweite, was zu relativ großen, mit der Brennweite anwachsenden Öffnungs- und Farbfehlerkonstanten führt. Durch die erfindungsgemäße Anordnung einer auf positiven Potential liegenden zylinderförmigen Elektrode RE im oberen Polschuhe OP, werden die Abbildungseigenschaften des aus konischer Magnetlinse ML und elektrostatischer Immersionslinse bestehenden korpuskularoptischen Einheit gegenüber der konischen Einzellinse deutlich verbessert. Diese Verbesserung der Abbildungseigenschaften erreicht man durch die schon beschriebene Verringerung der Fehlerkonstanten und eine Verschiebung der Hauptebenen der konischen Magnetlinse ML in Richtung der Probe, die aufgrund der damit einhergehenden Verkürzung der Brennweite kleinere Aberrationen aufweist ($C_F \sim$ Brennweite). Auch in diesem Ausführungsbeispiel bildet der vorzugsweise auf Erdpotential liegende untere Polschuh UP wieder eine Elektrode der elektrostatischen Immersionslinse.

Die erfindungsgemäßen elektrostatisch-magnetischen-Linsen werden vorteilhafterweise in Raster-Korpuskularmikroskopen, insbesondere in Raster-Elektronenmikroskopen eingesetzt, in denen der Boersch-Effekt die Auflösung insbesondere bei niedrigen Beschleunigungsspannungen begrenzt und konventionelle Linsensysteme zu große Aberrationen aufweisen. Da der Einfluß des lateralen Boersch-Effektes auf den Sondendurchmesser bei hohen kinetischen Energien abnimmt, die Breite der Energieverteilung der Primärelektronen insbesondere im Strahlerzeuger infolge des energetischen Boersch-Effektes aber deutlich zunimmt, sollten die Elektronen den ersten Strahlüberkreuzungspunkt (Quellen crossover) vorteilhafterweise mit niedrigen Energien (beispielsweise 2 keV) durchlaufen, um sie anschließend auf hohe Energien (beispielsweise 10 keV) zu beschleunigen und erst kurz vor Erreichen der Probe auf die gewünschte niedrige Endenergie (beispielsweise 1 keV) abzubremsen. Die Abbremsung und Fokussierung der Primärelektronen erfolgt hierbei vorteilhafterweise mit Hilfe einer erfindungsgemäßen elektrostatisch-magnetischen-Linse, die eine der konventionellen Kondensorlinsen oder die Objektivlinse in der elektronenoptischen Säule ersetzt und deren Zylinderelektrode RE bei einem angenommenen Kathodenpotential von - 1 kV, einer Beschleunigung der Primärelektronen auf 10 keV und einer gewünschten Endenergie der Primärelektronen von 1 keV auf Anodenpotential, also auf 9 kV liegt.

Bezugszeichenliste

| BL | Blende |
| IS | Isolator |
| ML | Magnetlinse |
| OA | Symmetrieachse der Magnetlinse |
| OP | oberer Polschuh der Magnetlinse |
| PS | Polschuhspalt |
| RE | Zylinderelektrode |
| SE | hohlzylinderförmige Elektrode |
| SF | Strahlführungsrohr |
| UP | unterer Polschuh der Magnetlinse |

**Patentansprüche**

1. Elektrostatisch-magnetische Linse fur Korpuskularstrahlgeräte mit einer ein nahezu rotationssymmetrisches magnetisches Feld erzeugenden Magnetlinse (ML) und einer innerhalb der Magnetlinse (ML) symmetrisch zu deren Symmetrieachse (OA) angeordneten elektrostatischen Linse, dadurch gekennzeichnet, daß die elektrostatische Linse durch eine ein nahezu rotationssymmetrisches elektrisches Feld erzeugende elektrostatische Immersionslinse, die mindestens zwei auf unterschiedlichem Potential liegende Elektroden (RE, UP) aufweist, gebildet wird.

2. Elektrostatisch-magnetische-Linse nach Anspruch 1, dadurch **gekennzeichnet,** daß ein Polschuh (UP) der Magnetlinse (ML) eine Elektrode der elektrostatischen Immersionslinse bildet.

3. Elektrostatisch-magnetische-Linse nach Anspruch 1 oder 2, dadurch **gekennzeichnet,** daß mindestens eine der Elektroden der elektrostatischen Immersionslinse in Form eines Hohlzylinders (RE) ausgebildet und konzentrisch zur Symmetrieachse (OA) im oberen Polschuh (OP) der Magnetlinse (ML) angeordnet ist.

4. Elektrostatisch-magnetische-Linse nach einem der Ansprüche 1 bis 3, dadurch **gekennzeichnet,** daß innerhalb einer der hohlzylinderförmigen Elektroden (SE) eine koaxial zu dieser angeordnete und ebenfalls in Form eines Hohlzylinders ausgebildete zweite Elektrode (RE) vorgesehen ist.

5. Elektrostatisch-magnetische-Linse nach einem der Ansprüche 1 bis 4, dadurch **gekennzeichnet,** daß innerhalb mindestens einer der Elektroden (RE, SE) eine leitend mit dieser Elektrode verbundenen Blende (BL) angeordnet ist.

6. Elektrostatisch-magnetische Linse nach einem der Ansprüche 1 bis 5, dadurch **gekennzeichnet**, daß mindestens eine der Elektroden (RE, SE) von einer Lochblende (BL) abgeschlossen wird.

7. Elektrostatisch-magnetische-Linse nach einem der Ansprüche 1 bis 6, dadurch **gekennzeichnet**, daß der untere Polschuh (UP) der Magnetlinse (ML) mit einem Strahlführungsrohr (SF) ausgekleidet ist.

8. Elektrostatisch-magnetische-Linse nach einem der Ansprüche 1 bis 7, **gekennzeichnet** durch eine symmetrische Magnetlinse (ML).

9. Elektrostatisch-magnetische-Linse nach einem der Ansprüche 1 bis 7, **gekennzeichnet** durch eine unsymmetrische Magnetlinse (ML).

10. Elektrostatisch-magnetische-Linse nach einem der Ansprüche 1 bis 7, **gekennzeichnet** durch eine konische Magnetlinse (ML).

**Claims**

1. Electrostatic-magnetic lens for corpuscular beam devices with a magnetic lens (ML) which produces a magnetic field which is almost rotationally symmetrical and an electrostatic lens arranged within the magnetic lens (ML) symmetrical to the axis of symmetry (OA) thereof, characterised in that the electrostatic lens is formed by an electrostatic immersion lens which produces an almost rotationally symmetrical electric field and which has at least two electrodes (RE, UP) at different potentials.

2. Electrostatic-magnetic lens as claimed in claim 1, characterised in that one pole piece (UP) of the magnetic lens (ML) forms one electrode of the electrostatic immersion lens.

3. Electrostatic-magnetic lens as claimed in claim 1 or claim 2, characterised in that at least one of the electrodes of the electrostatic immersion lens is constructed in the form of a hollow cylinder (RE) and is arranged concentrically with respect to the axis of symmetry (OA) in the upper pole piece (OP) of the magnetic lens (ML).

4. Electrostatic-magnetic lens as claimed in one of claims 1 to 3, characterised in that within one of the hollow cylindrical electrodes (SE) there is provided a second electrode (RE) which is arranged coaxially with respect to the former and is also constructed in the form of a hollow cylinder.

5. Electrostatic-magnetic lens as claimed in one of claims 1 to 4, characterised in that a plate (BL) is arranged within at least one of the electrodes (RE, SE) and conductively connected to the said electrode.

6. Electrostatic-magnetic lens as claimed in one of claims 1 to 5, characterised in that at least one of the electrodes (RE, SE) is closed off by a perforated plate (BL).

7. Electrostatic-magnetic lens as claimed in one of claims 1 to 6, characterised in that the lower pole piece (UP) of the magnetic lens (ML) is lined with a beam guide (SF).

8. Electrostatic-magnetic lens as claimed in one of claims 1 to 7, characterised by a symmetrical magnetic lens (ML).

9. Electrostatic-magnetic lens as claimed in one of claims 1 to 7, characterised by an asymmetrical magnetic lens (ML).

10. Electrostatic-magnetic lens as claimed in one of claims 1 to 7, characterised by a conical magnetic lens (ML).

**Revendications**

1. Lentille magnéto-électrostatique pour canons à corpuscules, comprenant une lentille magnétique (ML) produisant un champ magnétique à peu près symétrique de révolution et une lentille électrostatique disposée à l'intérieur de la lentille magnétique (ML) et symétrique par rapport à l'axe de symétrie (OA) de cette dernière, caractérisée en ce que la lentille électrostatique est formée d'une lentille électrostatique à immersion qui produit un champ électrique à peu près symétrique de révolution et qui comprend au moins deux électrodes (RE, UP) qui sont à des potentiels différents.

2. Lentille magnéto-électrostatique selon la revendication 1, caractérisée en ce qu'une pièce polaire (UP) de la lentille magnétique (ML) forme une électrode de la lentille électrostatique à immersion.

3. Lentille magnéto-électrostatique selon la revendication 1 ou 2, caractérisée en ce qu'au moins l'une des électrodes de la lentille électrostatique à immersion a la forme d'un cylindre creux (RE) et elle est disposée concentriquement à l'axe de symétrie (OA) dans la pièce polaire supérieure (OP) de la lentille magnétique (ML).

4. Lentille magnéto-électrostatique selon l'une des revendications 1 à 3, caractérisée en ce qu'une seconde électrode (RE) prévue à l'intérieur de l'une des électrodes cylindriques creuses (SE) est disposée coaxialement à cette dernière et a aussi la forme d'un cylindre creux.

5. Lentille magnéto-électrostatique selon l'une des revendications 1 à 4, caractérisée en ce qu'un diaphragme (BL) disposé à l'intérieur d'au moins l'une des électrodes (RE, SE) est connecté électriquement à cette électrode.

6. Lentille magnéto-électrostatique selon l'une des revendications 1 à 5, caractérisée en ce qu'au moins l'une des électrodes (RE, SE) est fermée par un sténopé (BL).

7. Lentille magnéto-électrostatique selon l'une des revendications 1 à 6, caractérisée en ce que la pièce polaire inférieure (UP) de la lentille magnétique (ML) est revêtue d'un tube (SF) de guidage du faisceau.

8. Lentille magnéto-électrostatique selon l'une des revendications 1 à 7, caractérisée par une lentille magnétique symétrique (ML).

9. Lentille magnéto-électrostatique selon l'une des revendications 1à 7, caractérisée par une lentille magnétique asymétrique (ML).

10. Lentille magnéto-électrostatique selon l'une des revendications 1 à 7, caractérisée par une lentille magnétique conique (ML).

## FIG 1

## FIG 2

## FIG 3

## FIG 4